# EUROPEAN PATENT APPLICATION

(11) **EP 4 675 230 A1**
(43) Date of publication of application: **07.01.2026**
(21) Application number: 24472011.6
(22) Date of filing: 04.07.2024
(51) Int. Cl.: G01D 3/028, G01D 5/251, H03K 17/00, G01R 33/00

(54) **POSITION SENSOR CIRCUIT**

(71) Applicant: Melexis Bulgaria EOOD, 1138 Sofia (BG)
(72) Inventor: Marinov, Tsvetan, 1138 Sofia (BG)
(74) Representative: Winger

(57) **Abstract**

The present invention relates to a position sensor circuit designed to detect a magnetic field and to provide an output indicative of its characteristics. The circuit includes a sensor (20) for generating an output signal corresponding to the magnetic field, a signal conditioning circuit (30) arranged to receive said output signal and to output a version of said output signal, a threshold circuit (40) arranged to define at least two pairs of thresholds and to store at least three current sink codes, and a comparison circuit (60) for comparing the version of the output signal against these thresholds to produce a comparison circuit output signal. A configurable logic circuit (80) is employed to select one of the at least three current sink codes based on the comparison circuit output signal. A current source circuit (90) is arranged to receive the selected current sink code and to output a current with a current value corresponding to the selected current sink code. This configuration allows for the determination of the magnetic field's polarity or strength, with the potential for detecting faulty states through specific threshold pairings.

## Description

### Field of the invention

The present invention is generally related to the field of electronic position sensing and more in particular of two-wire sensing circuits for position sensing.

### Background of the invention

Position sensors are integral components in a myriad of applications across various industries, including automotive, manufacturing, robotics, and consumer electronics. These sensors play a crucial role in detecting the position or movement of objects and converting the information into signals that can be measured and processed. Among the different types of position sensors, magnetic position sensors are particularly popular due to their non-contact nature and durability, as they can operate without physical contact with the object the position of which is to be measured. By measuring the strength of a magnetic field generated by one or more magnetic object(s) at various locations, the position or orientation of the object(s) relative to the sensor elements can be determined.

Two-wire sensors are known for their simplicity and cost-effectiveness. A two-wire sensor has, as the name indicates, only two wires to connect the power supply and to transmit the measured signal from the sensor. Typically, a two-wire sensor can transmit only two supply current levels or states, which represent the measurement results of the sensor. Therefore, only two mechanical positions of an object can be detected, i.e. a position where the object is close to the sensor and object detection is triggered because of the detected magnetic field of the object exceeds a threshold, or a position where the object is far away, and its magnetic field does not exceed the threshold. The selection of the current level is done by a comparator, which compares the measured magnetic field Bₘ to a pair of threshold values, one threshold (B_{OP}) related to an operating point and one threshold (B_{RP}) related to a release point and, based on the comparison result, selects the corresponding current level. B_{OP} corresponds to a value at which the measured magnetic field corresponds to the mechanical position of the object being close to the sensor. The release point B_{RP} is always smaller value than the B_{OP}. In this way hysteresis is brought to the system, which makes the sensor circuit more stable when operating around the operating point B_{OP}. A common implementation to introduce hysteresis in the detection of the object using a pair of thresholds is an SR flip-flop, or, in case of single comparator, switching between the two thresholds as the reference of the comparator. This threshold pair output is then used to select the transmitted supply current level.

In various applications, however, there is a need to detect more than two positions. The commonly encountered solution to achieve this in the prior art, is to use two separate sensor integrated circuits (ICs) to detect the three positions of the magnet. As already mentioned, two-wire sensors typically use only two supply current states, I_ON and I_OFF. Some ICs known in the art have selectable I_OFF currents, e.g., I_OFF1 and I_OFF2. With appropriate placement of the two sensors and appropriate setting of the magnetic thresholds and parallel connection of the two sensors the following different supply current states can for example be achieved: I_ON + I_OFF1, I_ON + I_OFF2 and I_ON + I_ON. Therefore, three positions can be detected. The three mechanical positions can be defined as different magnetic field polarities, such as South, North or the absence of a magnetic field, or as magnetic fields of the same polarity with varying strength.

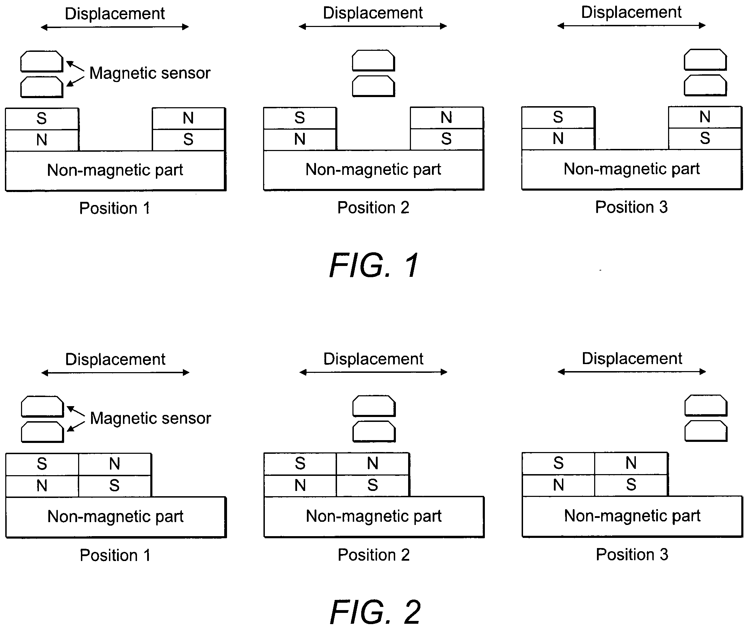

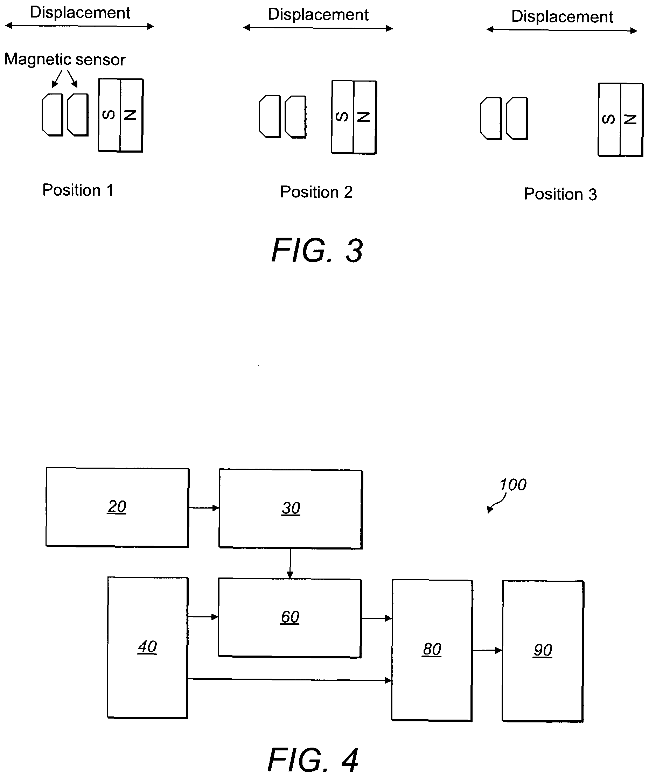

Fig.1 and Fig.2 depict some examples. In Fig.1 the magnets are positioned some distance apart from one another, whereas in Fig.2 the magnets are placed next to each other. Another possibility to define the three positions is to use the same polarity (South or North), but with different strength of the magnetic field. This is illustrated in Fig.3, wherein from left to right the various positions show an increasing distance between the sensors and the magnets.

Despite the ability to detect three positions using two separate ICs, this approach has its drawbacks. The use of two ICs increases the complexity of the system and may lead to challenges in distinguishing between different states due to the accumulation of tolerances and errors. Additionally, having two separate sensing spots can complicate the magnetic and mechanical design of the system.

There is a clear need for a two-wire sensor circuit wherein the drawback of having two separate ICs connected in parallel is avoided.

### Summary of the invention

It is an object of embodiments of the present invention to provide a two-wire sensor circuit enabling the detection of more than two positions of a magnetic object without the need for two separate integrated circuits connected in parallel.

The above objective is accomplished by the solution according to the present invention.

In a first aspect the invention relates to a position sensor circuit comprising a sensor arranged to generate an output signal indicative of a magnetic field, a signal conditioning circuit arranged to create from the output signal a version of the output signal, a threshold circuit arranged to define at least two pairs of thresholds and to store at least three current sink codes, a comparison circuit comprising at least one comparator arranged to compare the version of the output signal with the thresholds of the at least two pairs of thresholds and arranged to provide a comparison circuit output signal, a configurable logic circuit arranged to select one of the at least three current sink codes based on the comparison circuit output signal, and a current source circuit arranged to receive the selected current sink code and to output a current with a current value corresponding to the selected current sink code.

The proposed solution indeed allows for the generation of an output signal indicative of a magnetic field with high precision and reliability. The threshold circuit within the sensor circuit can define at least two pairs of thresholds, allowing for enhanced flexibility and functionality in detecting various magnetic field conditions. The threshold circuit also stores the current sink codes which correspond to the current levels. It is an additional advantage of embodiments of the present invention that the comparison circuit can compare the version of the sensor output signal with the thresholds of at least two pairs of thresholds, providing a robust comparison circuit output signal that can be used to accurately determine the position of a magnetic object.

In embodiments, the current source circuit may have three selectable current values and the magnetic field is determined via its magnetic field polarity or magnetic field strength. This embodiment allows for the detection of magnetic fields based on their polarity or strength, providing flexibility in sensor applications.

In embodiments, thresholds of one of the pairs of thresholds may be greater than the thresholds of the other pairs of thresholds. In this way it is ensured that the sensor can distinguish between different levels of magnetic fields, enhancing its accuracy.

In some embodiments, the current source circuit may have four selectable current values and the magnetic field is detected via its magnetic field strength. The magnetic field then maintains a same polarity. These embodiments allow for the detection of different strengths of magnetic fields while maintaining the same polarity, which is useful for detecting faults or specific conditions.

In embodiments, one pair of thresholds may comprise an upper value higher than the thresholds of another pair and a lower value lower than the thresholds of said other pair. Such an embodiment provides a means to set a range for detecting normal operation and fault conditions, improving the reliability of the sensor.

In embodiments, the thresholds of one pair may be used for detecting faulty states. This embodiment allows for the immediate identification of fault conditions, which is critical for safety and maintenance purposes.

In one embodiment the comparison circuit output signal comprises a threshold pair output and a comparator output.

In embodiments, the position sensor circuit may comprise an analog part and a digital part, whereby at least the sensor and the current output by the sensor circuit belong to the analog part and at least the configurable logic circuit belongs to the digital part. In some embodiments the signal conditioning circuit is responsible for the conversion from analog to digital representation of the version of the sensor output signal. This embodiment separates the processing of signals into the analog and digital domain, thereby optimizing the performance of the sensor circuit.

In advantageous embodiments, the threshold circuit may comprise memory. This embodiment allows storing digital values of the at least two pairs of thresholds, which can be useful for calibration and maintaining consistent performance over time.

In one embodiment, at least one comparator of the comparison circuit may be implemented as a digital adder. This embodiment allows for the integration of signals, which can simplify the design and improve the signal processing of the sensor circuit.

In a preferred embodiment the sensor may be a Hall sensor. Hall sensors for magnetic field detection are known for their reliability and sensitivity. It is widely known that Hall sensors operate based on the Hall effect, where a voltage is generated perpendicular to both the direction of an electric current and an external magnetic field. Hall sensors are commonly used to measure magnetic field strength and polarity.

In other embodiments the current values of the current output by the sensor circuit may be in a range of 3 mA (lowest selectable current value) to 30 mA (highest selectable current value). This wide range of current outputs allows for greater flexibility in signalling and communication with external systems. This range is suitable for various applications where different levels of current are required to indicate different states or conditions detected by the sensor.

It is an advantage of embodiments of the present invention that a current source circuit comprising at least three selectable current values can be included, enabling the sensor circuit to output a current value that is indicative of the detected magnetic field condition. It is a further advantage of embodiments of the present invention that a configurable digital logic circuit can select one of the at least three selectable current values based on the comparison circuit output signal, thereby simplifying the process of signal interpretation and improving the sensor's response time.

It is an advantage of embodiments of the present invention that the sensor circuit can be configured to determine the magnetic field via its magnetic field polarity or magnetic field strength, which enhances the versatility of the sensor in various application scenarios. It is an additional advantage of embodiments of the present invention that the thresholds of one of the pairs of thresholds can be set greater than the thresholds of the other pairs, which can be instrumental in creating a more nuanced and sensitive detection mechanism.

It is an advantage of embodiments of the present invention that the current source circuit can have four selectable current values, and the magnetic field can be detected via its magnetic field strength while maintaining a same polarity, which is particularly useful in applications requiring a high degree of specificity in magnetic field detection. It is a further advantage of embodiments of the present invention that one pair of thresholds can comprise an upper value higher than the thresholds of another pair and a lower value lower than the thresholds of said other pair, which can be beneficial for detecting faulty states and ensuring the reliability of the sensor circuit.

It is an advantage of embodiments of the present invention that the position sensor circuit can comprise an analog part and a digital part, with at least the sensor and the current output by the sensor circuit belonging to the analog part and at least the decision logic belonging to the digital part, thus optimizing the signal processing chain for better performance. Various ways to split up in analog and digital part can be envisaged, which is reflected in how the signal conditioning circuit is implemented. It is an additional advantage of embodiments of the present invention that the threshold circuit can include memory, such as for example EEPROM, which allows for the customization and fine-tuning of threshold values based on specific application requirements.

It is an advantage of embodiments of the present invention that at least one of the comparators can be implemented as a digital adder, which can contribute to a more compact and efficient design of the sensor circuit. It is a further advantage of embodiments of the present invention that the sensor can be a Hall sensor, known for its sensitivity and accuracy in detecting magnetic fields. It is an additional advantage of embodiments of the present invention that the current values of the current output by the sensor circuit can be in a range of 3 to 30 mA, offering a wide range of output levels to accommodate various power requirements and signalling needs.

For purposes of summarizing the invention and the advantages achieved over the prior art, certain objects and advantages of the invention have been described herein above. Of course, it is to be understood that not necessarily all such objects or advantages may be achieved in accordance with any particular embodiment of the invention. Thus, for example, those skilled in the art will recognize that the invention may be embodied or carried out in a manner that achieves or optimizes one advantage or group of advantages as taught herein without necessarily achieving other objects or advantages as may be taught or suggested herein.

The above and other aspects of the invention will be apparent from and elucidated with reference to the embodiment(s) described hereinafter.

### Brief description of the drawings

The invention will now be described further, by way of example, with reference to the accompanying drawings, wherein like reference numerals refer to like elements in the various figures.
Fig.1 illustrates an example of a position sensor circuit with magnets with different polarity.
Fig.2 illustrates another example of a possible positioning of sensors and magnets.
Fig.3 illustrates a position sensor circuit with varying magnetic field strengths according to embodiments of the present invention.
Fig.4 illustrates a general block schema of a position sensor circuit according to the invention.
Fig.5 illustrates a possible implementation of the scheme of Fig.4 in one embodiment of the position sensor circuit.
Fig.6 illustrates the relationship between magnetic field and output states in Configuration 1 of the position sensor circuit according to embodiments of the present invention.
Fig.7 is a schematic representation of detectable positions for a magnetic sensor in relation to a magnet according to embodiments of the present invention.
Fig.8 illustrates the relationship between magnetic field and output states in Configuration 2 of the position sensor circuit according to embodiments of the present invention.
Fig.9 illustrates an example of the operation of the position sensor circuit.
Fig.10 illustrates a table comprising the digital values of the various components in Fig.9 in each transition.

### Detailed description of illustrative embodiments

The present invention will be described with respect to particular embodiments and with reference to certain drawings but the invention is not limited thereto but only by the claims.

Furthermore, the terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

It should be noted that the use of particular terminology when describing certain features or aspects of the invention should not be taken to imply that the terminology is being redefined herein to be restricted to include any specific characteristics of the features or aspects of the invention with which that terminology is associated.

In the description provided herein, numerous specific details are set forth. However, it is understood that embodiments of the invention may be practiced without these specific details. In other instances, well-known methods, structures and techniques have not been shown in detail in order not to obscure an understanding of this description.

In order to solve the above-mentioned problem, the present invention proposes in one aspect a position sensing circuit. Fig.4 provides a generic block scheme of the proposed circuit. The circuit comprises
- a sensor (20) arranged to generate a sensor output signal indicative of a magnetic field,
- a signal conditioning circuit (30) arranged to receive the sensor output signal and to output a version of the sensor output signal,
- a threshold and current level circuit (40) arranged to define at least two pairs of thresholds and to store at least three current sink codes, each corresponding to a selectable current level value,
- a comparison circuit (60) arranged to compare the version of the sensor output signal with the thresholds of the at least two pairs of thresholds and to provide a comparison circuit output signal,
- a configurable logic circuit (80) arranged to select one of the at least three selectable current values based on the comparison circuit output signal,
- a current source circuit (90) that receives the selected current sink code and outputs a current with a current level value corresponding to the selected current sink code.

As used herein, and unless otherwise specified, the term "sensor arranged to generate an output signal indicative of a magnetic field" refers to a device or component that detects magnetic fields and converts the detected information into an electrical signal that represents the characteristics of the magnetic field, such as its strength or polarity. Examples of specific embodiments of such sensors include Hall effect sensors and magnetoresistive (xMR) sensors.

Hall sensors suffer from offset. Offset in Hall sensors can be divided into two contributions: the raw offset and residual offset. The raw offset is caused by process variations during the chip manufacturing and temperature gradient caused by heat sources in the chip. The spinning/chopping of the Hall output signal is a known method to cancel the raw offset. The raw offset cancelation may be done in the analog domain before an Analog-to-Digital Converter, ADC, but for a simpler and smaller silicon area implementation, it is often done after converting the signal to the digital domain. The residual offset is what is left from the offset after the raw offset cancelation. Whereas the raw offset cancelation is based only on measurement in different states in a Hall sensor spinning technique, the residual offset compensation is based on trimming and is assumed to be constant for each Hall sensor device. The residual offset is measured by test equipment in a final test stage and the digital value of the residual offset is programmed in the chip. The chip then simply subtracts this constant from all magnetic measurements after raw offset compensation. Preferably, also this is performed in the digital domain. In addition to the offset compensations, also temperature compensation may be performed for each measurement. For this purpose, the sensor temperature is measured. The temperature compensation is applied to the thresholds to compensate the temperature coefficient of the magnet. As the magnetic field from the magnet reduces with increasing temperature, the magnetic thresholds must also decrease in order to keep the activation distance between the chip and the magnet constant over temperature.

As shown in Fig.4, the sensor output signal is applied to a signal conditioning circuit 30 that outputs a version of the input signal. The actual implementation of the signal conditioning circuit depends on whether the signal fed to the comparison circuit is analog or digital and on which functionalities are implemented to be performed inside the block. In case of a digital output signal, the signal conditioning circuit comprises an analog-to-digital converter, ADC, to sample and convert the sensed signal to a digital representation. In typical embodiments the ADC is preceded by an amplifier to amplify the weak sensor signal. A further functionality that may be implemented in this functional block in cases where the sensor is a Hall sensor, is demodulation of the Hall-sensor spinning. This is performed to cancel the raw offset of the sensor. Preferably this is performed in the digital domain, i.e. after the A/D conversion, but it may also be carried out in the analog domain before the ADC. Hence, an amplified and digitized version of the sensor output signal from which the raw offset is cancelled is then fed to the comparison circuit. In case the comparison circuit receives an analog input signal, the signal conditioning circuit may contain only an amplifier to bring the sensed sensor output signal to a higher amplitude level. This is for example the case when an xMR sensor is employed. The input signal to the comparison circuit then is an amplified version of the sensor output signal.

The threshold circuit and current level circuit 40 is to be construed as an electronic circuit that establishes and stores multiple sets of two threshold levels each, which are used to evaluate the version of the output signal from the sensor. It further stores the output current level values as "current sink codes" to be provided to the current source circuit, as will be explained later. The storage is preferably non-volatile and may include elements such as registers, memory chips, or non-volatile memory like, e.g., EEPROM or flash memory.-The thresholds are reference values against which the received version of the sensor's output signal is compared to determine the state of the magnetic field. For example, one pair of thresholds might be set to detect a weak magnetic field, while another pair might be set to detect a strong magnetic field. The threshold and current level circuit is in preferred embodiments implemented digitally, but in other embodiments, when analog values are used for comparing, an analog implementation can be adopted, e.g. using hard wired resistors (voltage dividers). If the threshold values are stored digitally, digital-to-analog conversion means are obviously required before the comparing operation can be performed. In a digital implementation the threshold circuit can in one embodiment be implemented as a set of instructions within the digital system.

The comparison circuit 60 is preferably implemented in the digital domain. In some embodiments the comparison circuit is implemented as an electronic circuit, e.g. a digital adder, or an algorithm that receives the version of the sensor output signal coming out of the signal conditioning circuit and the defined threshold values from the threshold and current level circuit 40, performs a comparison to determine whether the sensor output signal is above or below each threshold, and then generates a digital comparison circuit output signal 64 based on these comparisons. In preferred embodiments the comparison circuit comprises at least two comparators. In principle, the comparison circuit may consist of a single comparator, but that would come at the cost of an increased reaction time. Examples of specific implementations of comparators that can be envisaged for use include digital comparison circuits, e.g. adders, or software routines executed on a microcontroller. When using an adder as the comparator, the output of the comparator is the sign of the adder output.

In some embodiments an analog comparator may be used. In one possible analog implementation the comparator is an open loop operational amplifier. If the threshold values are stored as digital values in the threshold and current level circuit 40, a Digital-to-Analog Converter (DAC) is needed between the circuit 40 and the comparison circuit 60.

The current source circuit 90 is capable of providing a controlled amount of current, whereby the magnitude of the current can be selected from at least three predetermined values defined by the current sink codes. Examples of specific embodiments of the current source circuit include digitally controlled current sources, current mirrors with selectable ratios, programmable current regulators and DACs with current output.

The configurable logic circuit 80 is a digital circuit that can be programmed or configured to choose one of the available current sink codes from the threshold and current level circuit 40, using the output signals from the comparators as input to make this selection. Examples of specific embodiments include microcontrollers, digital logic circuits implemented with logic ports and field-programmable gate arrays (FPGAs).

Magnetic field polarity and magnetic field strength are the two primary characteristics of a magnetic field that can be detected. Magnetic field polarity indicates the direction of the magnetic field, whereas magnetic field strength quantifies the intensity of the magnetic field. Examples of specific embodiments include detecting the North and South poles of a magnet for polarity and measuring the magnetic flux density in Tesla or Gauss for strength.

As already mentioned above, in the sensor circuit an analog part and a digital part can be identified. The analog part is responsible for processing real-world continuous signals, such as the sensor's output signal, and the digital part handles discrete digital signals, such as the signals in the decision logic circuit for controlling the current source circuit. Examples of specific embodiments of the analog part include amplifiers, filters, and analog-to-digital converters, while the digital part may include microprocessors, digital signal processors, digital logic circuits, and digital memory.

As set out above, in order to integrate the two discrete sensors in one circuit or device, the present invention proposes to add a second pair of magnetic thresholds (Bop2 and Brp2) and two additional supply current levels, making the total amount of output states four. Therefore, three or four positions of the magnet can be detected, depending on the configuration.

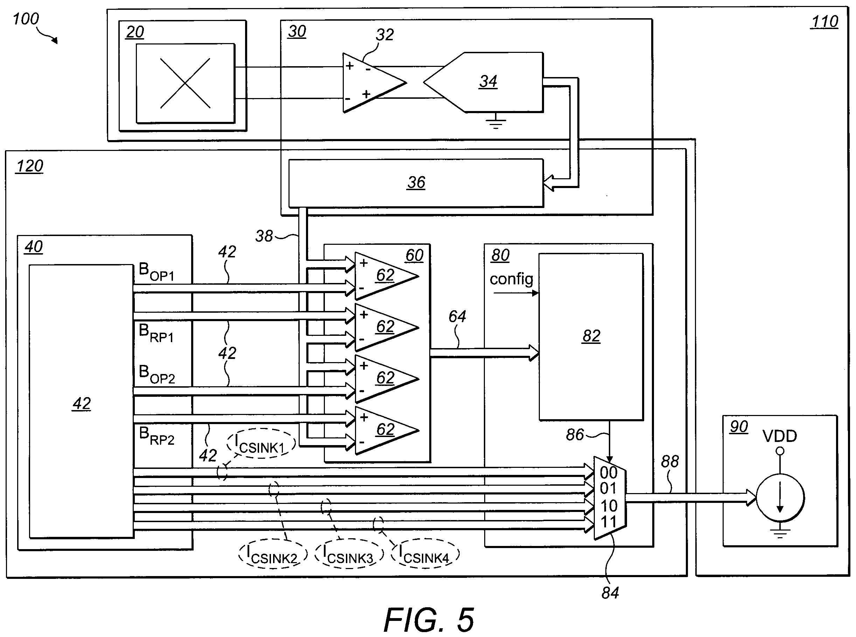

Fig.5 is a block scheme of a possible embodiment of the two-wire sensor circuit 100 according to the invention, with in the embodiment depicted in Fig.5 in the analog domain (110) a Hall sensor (20) for magnetic field detection, a signal conditioning circuit (30) comprising an amplifier (32) and an analog-to-digital converter (ADC) (34), and a programmable current source circuit (90). All the signal processing in the embodiment depicted in Fig.5 is done in the digital domain (120). Note it is possible to make the division between the domains differently compared to Fig.5 and implement more in the analog domain. However, it is clear for a skilled person that if e.g. the sensing signal and the thresholds are implemented in analog domain, the comparators (62) of the comparison circuit (60) need to be analog comparators.

In Fig.5 the magnetic field is sensed by the Hall sensor 20 and converted to voltage. Then the voltage is amplified by the amplifier 32 and it is converted to a digital code by the ADC 34. Chopping and spinning of the Hall sensor may be applied to the signal chain, for example in the ADC post-processing block 36 in the digital domain. In this way the raw offset of the Hall sensor and the amplifier can be cancelled. The output of the ADC post-processing block is a digital representation, which is conveyed as a first input to the comparison circuit 60 in Fig.5.

The circuit 100 further comprises a storage circuit 42 for storing magnetic threshold pairs (Bop1, Brp1 and Bop2, Brp2), each of which is conveyed to a second input of a different comparator 62. The storage circuit further stores current sink codes (Icsink1, Icsink2, Icsink3, Icsink4), which are used to control the current source block 90. For example, the storage circuit may be an EEPROM to store the values in digital form. The storage means are shown in Fig.5 as part of the threshold and current level circuit 40 and therefore part of the digital domain 120.

The digital domain 120 in the embodiment of Fig.5 further comprises four comparators 62 and a configurable decision logic. The four comparators are shown for illustrative purposes. In case of a digital implementation, the comparators may be realised using one or more digital adders. In case the comparing is performed in the analog domain, at least one DAC may be required to convert the threshold levels to an analog representation, as mentioned earlier.

The ADC post-processing result is compared to the predefined magnetic thresholds (Bop1, Brp1, Bop2, Brp2), stored in the storage means, e.g. an EEPROM. The magnetic thresholds and the magnetic signal advantageously also have the residual offset compensation, omitted in Fig.5 for simplicity. In some embodiment the residual offset may be a constant value programmed in the sensor circuit 100 after it was measured at the end of the manufacturing process. The constant value is then subtracted from the magnetic field measurements after performing raw offset compensation. The signal conditioning circuit 30 of Fig.4 or the ADC post-processing block 36 of Fig.5 can be configured to perform these steps. Alternatively, these processing steps can be carried out on the stored threshold values in the threshold and current level circuit block 40 of Figs.4 and 5. Temperature compensation may be applied on the magnetic threshold in some embodiments. In other embodiments the compensation may be performed on the magnetic signal.

The supply current level of the position sensor circuit is changed using the programmable current source circuit 90. The supply current level is controlled by the configurable logic circuit 80, which comprises a decision logic circuit 82 that selects based on a combination of the comparison circuit output 64 the current sink code used for controlling the current source circuit. The output 86 of the decision logic is used to control the multiplexer 84 of the configurable logic circuit for the selection of the current sink code and to transmit the selected code as an output 88 to the current source circuit 90. The current sink codes may, for example, be of 6 bits. There may be more than one logic configuration in the decision logic circuit 82. The selection between the configurations can be made by controlling the 'config' input of the decision logic 82.

Two different exemplary configurations, called Configuration 1 and Configuration 2, are described to illustrate the operation of the position sensing circuit. As said, the selection between the configurations may be done using the additional input 'config' to decision logic circuit 82 in Fig. 5.

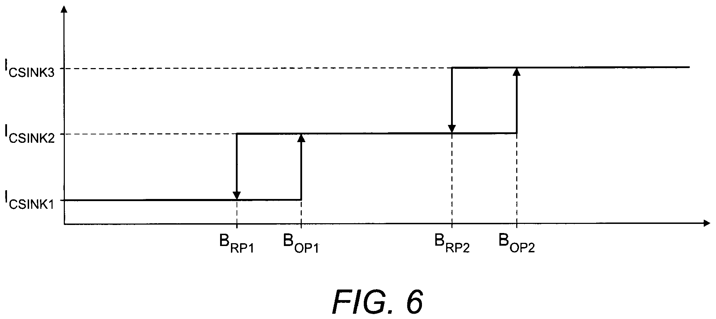

Configuration 1 is a direct replacement of the two-chip solution and is intended for detecting three positions using four magnetic thresholds. In terms of mechanical design, the three positions are defined in the same way, i.e. the setup allows varying the position of magnets with different polarities and strengths relative to the sensor, just as was already depicted in Figs.1, 2, and 3, but with one sensor now instead of two. Configuration 1 is using the threshold pair output, i.e. the output with the hysteresis of both sets of thresholds (e.g. the outputs of the RS flip-flops). Fig.6 depicts the transfer function for Configuration 1, correlating magnetic field strength with output states. Icsink1, Icsink2 and Icsink3 are the supply current states of the chip (output states). In the diagram Icsink3 > Icsink2 > Icsink1 this is only for illustrative purposes. The three current levels are fully independent from each other.

In this configuration the threshold values of one specific pair can be set higher than the threshold values of the other pair(s), which allows for differentiation between different magnetic field levels or ranges of the sensor's output signal. For example, a higher pair of thresholds might be used to detect a strong magnetic field, while lower pairs might be used for weaker fields.

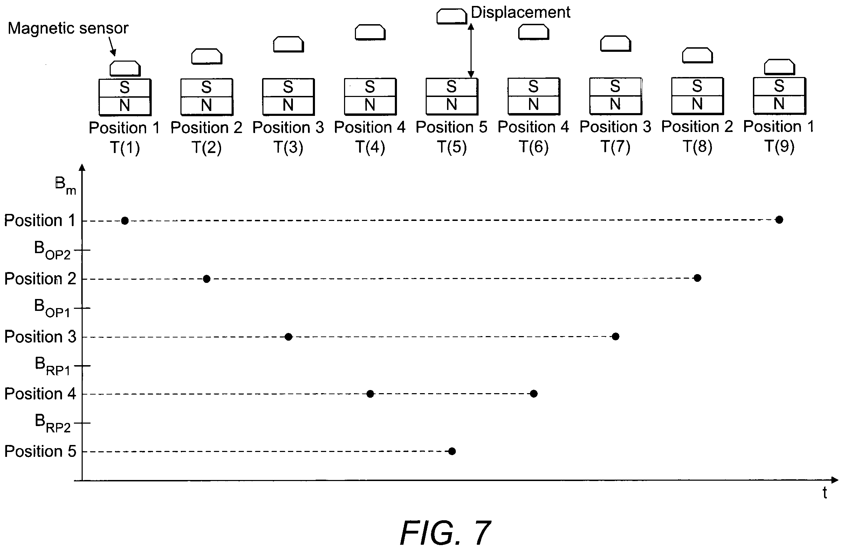

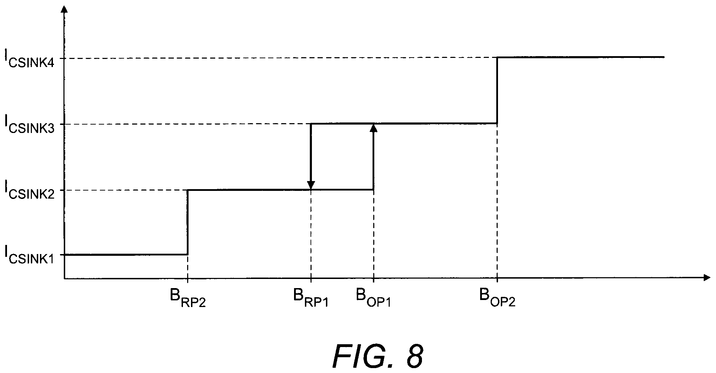

Configuration 2 allows detecting up to four positions using four output current states. Configuration 2 is preferably usable for magnetic fields with one and same polarity and different strength. It makes use of the threshold pair output of the first set of thresholds and the independent state of each threshold of the second set of thresholds, so that in this configuration four output states are possible. Configuration 2 is appropriate for example for use cases where the Bop1 and Brp1 are the normal operating thresholds and a magnetic field higher than Bop2 or lower than Brp2 can be considered a fault. Fig.7 shows all possible detectable positions of the magnetic sensor in relation to the magnet whereby it is further assumed that the positions are consecutive also in time. Fig.8 illustrates the relationship between magnetic field an output state. Thereby holds Icsink1 < Icsink2 <Icsink3 < Icsink4. Similar to Configuration 1 this is only for illustrative purposes and Icsink1, Icsink2, Icsink3 and Icsink4 are fully independent from each other. The faulty states Icsink1 and Icsink4 can be communicated to the outside world with two different current levels or one and the same.

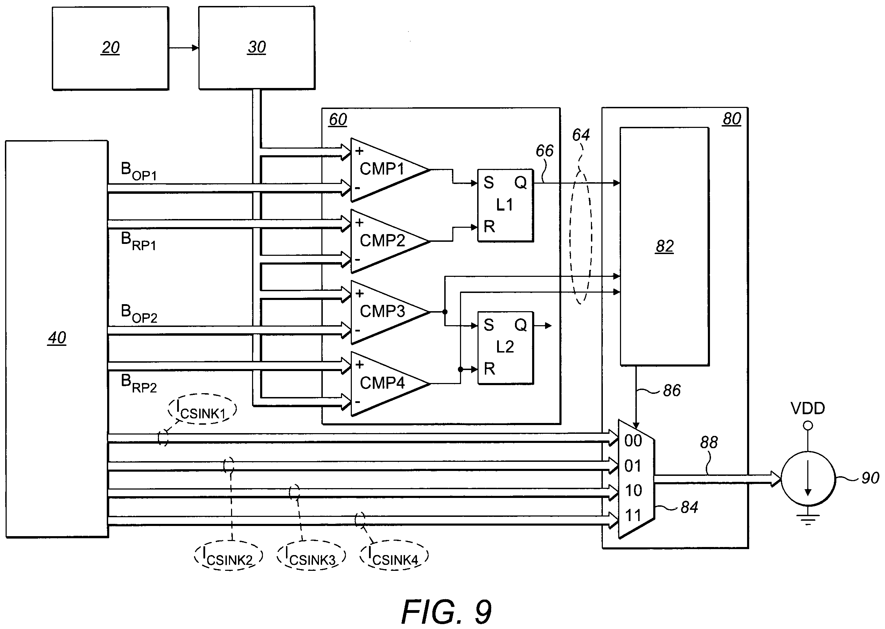

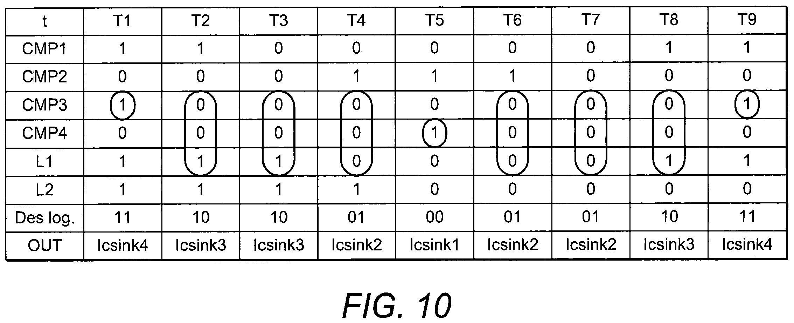

As an illustrative example, a possible implementation of the decision logic 82 is described in relation to Configuration 2 using Figs.9 and 10. Fig.9 uses the same references as Fig.5 but shows only the parts that are relevant for the describing the implementation of the decision logic in detail.

Fig.9 shows the comparison circuit 60 with four comparators and two SR flip flops for providing the threshold pair output with hysteresis. The threshold and current level circuit 40 comprises the two required threshold pairs and four separate current sink values. The multiplexer 84 is implemented such that the binary input '00' from the decision logic 82 selects the 'Icsink1'; input '01' selects 'Icsink2'; input '10' selects 'Icsink3'; and input '11' selects 'Icsink4' as its output 88, which is then used to control the current source circuit 90 as described earlier.

Fig.10 shows a table of all the outputs of the comparators (CMP1 to CMP4) and the SR flip flops (L1, L2) at each time T1 to T9 and corresponding position of the magnet in Fig.7. The 'Des.log.' line shows the expected output of the decision logic circuit 82, which corresponds to the current level of Fig.8. The table in Fig.10 can be used as a truth table for designing a logic circuit to implement the desired selections. It can be seen e.g. that to output '11', the decision logic only needs to detect if the comparator CMP3 output goes to logic '1'. This leads to the current sink code Icslink4 being selected and the multiplexer 84 outputs that value to the programmable current source circuit 90. Similarly, for each possible multiplexer output, a combination of inputs from the comparison circuit 60 can be selected. As it can be seen from the table in Fig.10, it is sufficient if the outputs of comparators CMP3 and CMP4, along with the flip-flop L1 output, are provided as the input to the decision logic circuit 82. These connections are also shown in Fig.9. Therefore, the comparison circuit output signal 64 comprises the threshold pair output 66 of SR flip-flop L1, and the comparator outputs of the comparators CMP3 and CMP4. This comparison output signal 64 is provided as an input to the decision logic circuit 82. Naturally, other combinations of the signals from the comparison circuit are possible to achieve the same result or for different configuration.

In one embodiment the set-up of Configuration 2 also works with different polarities. For example, threshold levels Bop1/Brp1 may be South/North (magnetic latch) and Bop2/Brp2 are also South/North but with a higher value. If Bop2 or Brp2 are crossed, this indicates an abnormally strong magnetic field. Abnormally weak magnetic field cannot be detected since it is part of the normal operating range.

In another configuration the threshold values are so arranged that one pair has an upper threshold that is higher than the upper threshold of another pair and a lower threshold that is lower than the lower threshold of the other pair, creating a wider range for detection between these two threshold pairs. This can be used to set a specific detection window for the sensor's output signal.

A specific pair of thresholds can be used to identify abnormal or error conditions in the sensor or the system it is monitoring. When the sensor's output signal falls outside the normal operating range and crosses these thresholds, it indicates a potential fault or malfunction. Examples of specific embodiments include detecting short circuits, open circuits, or out-of-range magnetic field strengths.

Using only one IC with fully adjustable supply current states allows selecting supply currents with sufficient difference in order to easily distinguish the different states. In the case of the two different sensors in parallel the states I_ON + I_OFF1 and I_ON + I_OFF2 can be difficult to distinguish from each other due the error stack up (the tolerance of the I_ON current may be comparable to the difference of the two smaller currents I_OFF1 and I_OFF2). Just to give one example, I_ON can be 14 mA, I_OFF1 3 mA and I_OFF2 6 mA.

Using only one sensor circuit implies that only one sensor, e.g. a Hall sensor, is required for all thresholds and only one sensing spot is used. This significantly reduces the complexity of the magnetic/mechanical design of the system.

While the invention has been illustrated and described in detail in the drawings and foregoing description, such illustration and description are to be considered illustrative or exemplary and not restrictive. The foregoing description details certain embodiments of the invention. It will be appreciated, however, that no matter how detailed the foregoing appears in text, the invention may be practiced in many ways. The invention is not limited to the disclosed embodiments.

Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. A single processor or other unit may fulfil the functions of several items recited in the claims. The mere fact that certain measures are recited in mutually different dependent claims does not indicate that a combination of these measures cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

## Claims

1. Position sensor circuit (100) comprising
- a sensor (20) arranged to generate an output signal indicative of a magnetic field,
- a signal conditioning circuit (30) arranged to receive said output signal and to output a version of said output signal,
- a threshold circuit (40) arranged to define at least two pairs of thresholds and to store at least three current sink codes,
- a comparison circuit (60) comprising at least one comparator arranged to compare said version of said output signal with said thresholds of said at least two pairs of thresholds and arranged to provide a comparison circuit output signal (64),
- a configurable logic circuit (80) arranged to select one of said at least three current sink codes based on said comparison circuit output signal,
- a current source circuit (90) arranged to receive said selected current sink code and to output a current with a current value corresponding to said selected current sink code.

2. Position sensor circuit as in claim 1, wherein said current source circuit has three selectable current values and wherein said magnetic field is determined via its magnetic field polarity or magnetic field strength.

3. Position sensor circuit as in claim 2, wherein thresholds of one of the pairs of thresholds are greater than the thresholds of the other pairs of thresholds.

4. Position sensor circuit as in claim 1, wherein said current source circuit has four selectable current values and said magnetic field is detected via its magnetic field strength and wherein said magnetic field maintains a same polarity.

5. Position sensor circuit as in claim 4, wherein one pair of thresholds comprises an upper value higher than the thresholds of another pair and a lower value lower than the thresholds of said other pair.

6. Position sensor circuit as in claim 5, wherein the thresholds of said one pair are used for detecting faulty states.

7. Position sensor circuit as in any of the previous claims, wherein said comparison circuit output signal comprises a threshold pair output and a comparator output value.

8. Position sensor circuit as in any of the previous claims, comprising an analog part and a digital part, at least said sensor and said current output by the sensor circuit belonging to the analog part and at least said configurable logic circuit belonging to the digital part.

9. Position sensor circuit as in any of the previous claims, comprising a signal conditioning circuit arranged to derive from said output signal indicative of a magnetic field said version of said output signal.

10. Position sensor circuit as in claim 9, wherein said signal conditioning circuit comprises an operational amplifier.

11. Position sensor circuit as in claim 10, wherein said signal conditioning circuit further comprises an analog-to-digital converter.

12. Position sensor circuit as in any of the previous claims, wherein the threshold circuit comprises a storage circuit to store digital values of said at least two pairs of thresholds.

13. Position sensor circuit as in any of the previous claims, wherein at least one of said comparators is implemented as a digital adder.

14. Position sensor circuit as in any of the previous claims, wherein said sensor is a Hall sensor.

15. Position sensor circuit as in any of the previous claims, wherein the current vales of said current output by said sensor circuit are in a range of 3 to 30 mA.
